(19) Europäisches Patentamt
European Patent Office
Office européen des brevets

(11) **EP 4 439 373 A1**

(12) **EUROPEAN PATENT APPLICATION**

(43) Date of publication:
**02.10.2024 Bulletin 2024/40**

(21) Application number: **23214878.3**

(22) Date of filing: **07.12.2023**

(51) International Patent Classification (IPC):
**G06F 30/337** (2020.01)  **G03F 1/36** (2012.01)
**G03F 7/00** (2006.01)

(52) Cooperative Patent Classification (CPC):
**G03F 1/36; G03F 7/70441; G06F 30/337**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2023 US 202318192204**

(71) Applicant: **INTEL Corporation**
**Santa Clara, CA 95054 (US)**

(72) Inventors:
- **THULASI, Sunita**
  **Portland, OR 97229 (US)**
- **ALDEN, Dorian**
  **Portland, OR 97209 (US)**

- **HORSCH, Mark**
  **Missouri City, TX 77459 (US)**
- **JONAYAT, A S M**
  **North Plains, OR 97133 (US)**
- **LEE, Cheng-Tsung**
  **Beaverton, OR 97006 (US)**
- **LIONG, Silvia**
  **Portland, OR 97221 (US)**
- **MORTON, Seth**
  **Beaverton, OR 97006 (US)**
- **RAHAL-ARABI, Omar**
  **Tigard, OR 97223 (US)**
- **SIDDHAMSHETTY, Prashanth Kumar**
  **Portland, OR 97239 (US)**

(74) Representative: **HGF**
**HGF Limited**
**1 City Walk**
**Leeds LS11 9DX (GB)**

(54) **ENHANCED RULE-BASED SHIFTING OF INTEGRATED CIRCUIT VIAS LAYOUTS TO MATCH METALS DURING OPTICAL PROXIMITY CORRECTIONS**

(57) This disclosure describes systems, methods, and devices related to shifting layouts of electronic circuit vias during optical proximity corrections (OPC). A method may include identifying a first metal line, of an electronic circuit, drawn at a first position; identifying a second metal line, of the electronic circuit, drawn at a second position; identifying a via drawn at a third position extending between the first metal line and the second metal line; determining a fourth position to which the first metal line is to move from the first position; determining a fifth position to which the second metal line is to move from the second position; determining, based on the fourth position, the fifth position, a sixth position to which the via is to move from third position; and generating a layout for generating a photomask for the via at the sixth position.

FIG. 9

## Description

### TECHNICAL FIELD

This disclosure generally relates to devices, systems, and methods for optical proximity corrections for integrated circuits and, more particularly, to shifting of integrated circuit vias during optical proximity corrections.

### BACKGROUND

Integrated circuit manufacturing often uses a photomask as a template for a given integrated circuit design. Optical proximity corrections (OPC) may modify mask patterns to improve printability of an integrated circuit wafer. Some OPC techniques may result in significant movement and sizing changes of metal lines from drawn positions, reducing overlap with vias and risking electrical shorts.

### BRIEF DESCRIPTION OF THE DRAWINGS

FIG. 1 is an example schematic drawing of optical proximity corrections (OPC) to determine placement of vias in a computer chip, according to some example embodiments of the present disclosure.
FIG. 2 illustrates example an example schematic drawing of metrics for determining the placement of vias in a computer chip in OPC, in accordance with one or more example embodiments of the present disclosure.
FIG. 3A illustrates example via overlap in a computer chip in OPC, in accordance with one or more example embodiments of the present disclosure.
FIG. 3B illustrates example electrical shorting risk in a computer chip in OPC, in accordance with one or more example embodiments of the present disclosure.
FIG. 4 illustrates an example scanning electron microscope image of a computer chip in OPC for determining the placement of vias, in accordance with one or more example embodiments of the present disclosure.
FIG. 5 illustrates an example schematic drawing of a computer chip in OPC for determining placement of vias, in accordance with one or more example embodiments of the present disclosure.
FIG. 6 illustrates an example schematic drawing of a computer chip in OPC for determining placement of vias, in accordance with one or more example embodiments of the present disclosure.
FIG. 7 illustrates a flow diagram of an illustrative process for determining the placement of vias in a computer chip in OPC, in accordance with one or more example embodiments of the present disclosure.
FIG. 8 illustrates an example schematic for extending a metal line of a computer chip in OPC when determining the placement of vias, in accordance with one or more example embodiments of the present disclosure.
FIG. 9 illustrates a flow diagram of an illustrative process for determining the placement of vias in a computer chip in OPC, in accordance with one or more example embodiments of the present disclosure.
FIG. 10 illustrates an embodiment of an exemplary system, in accordance with one or more example embodiments of the present disclosure.

### DETAILED DESCRIPTION

The following description and the drawings sufficiently illustrate specific embodiments to enable those skilled in the art to practice them. Other embodiments may incorporate structural, logical, electrical, process, algorithm, and other changes. Portions and features of some embodiments may be included in, or substituted for, those of other embodiments. Embodiments set forth in the claims encompass all available equivalents of those claims.

Integrated circuit manufacturing often uses a photomask as a template for a given integrated circuit design. Optical proximity corrections (OPC) may modify mask patterns to improve printability of an integrated circuit wafer. The move towards ease of use design rules has resulted in a much less restrictive and easier to implement set of layout rules for the metal routing layers. The less restrictive rules result in metal layouts that have a very large combination of metal line widths and pitches. The large combination of widths and pitches requires advanced OPC techniques to ensure a healthy process window during manufacturing. These OPC techniques result in large movements of the metal lines from their drawn positions as well as sizing changes in the lines themselves. Subsequently, the shifts and sizing changes can result in reduced metal via overlap and although they improve the process window for the metals can actually reduce the overall integrated margin.

The enhancements herein provide a rule-based algorithm (e.g., Pitch aware correction (PAC)) that is used to identify how to shift the vias to maximize the via-metal overlap without reducing the electrical shorting margin. The enhancements herein allow for more significant via shifting, and for extension of metal lines to allow for via shifting that improves performance and is less sensitive to mis-registration between metal layers. In particular, PAC may allow for determining how much the metal lines above and below a via will move, and how much a via needs to move accordingly to maximize overlap of the via with the metal lines above and below the via.

In one or more embodiments, PAC-based via chasing follows metal lines of a chip as hey shift and change size, allowing for an improved process window. PAC uses a rule-based equation to predict movement of the metal lines based on a space imbalance to the left and right of a metal line. The vias may follow the metal line shift while complying with via pattern requirements (e.g., not having vias too close to one another). Advantages of the via chasing implementation include a larger process window in the fabrication process, and thus tools may not have to run as tight of tolerances, so overall processing time is reduced. The via metal overlap can be modified as needed based on new fabrication learnings. The improved overlap should provide higher yield, even in cases where the tool tolerances are very tight.

A functional purpose of a via layer in a chip is to connect the metal layers running above the via layer to the metal layers below. The degree of overlap of the via with the metal to which the via connects is a metric that directly ties to both yield and performance. Via overlap is important for both the via to metal above layer and the via to metal below layer. In one or more embodiments, a combined via overlap metric is defined, and combines the overlap area of the via with both metal layers to which the via connects (e.g., a combined overlap between the via and metal layer above, and the via and the metal layer below). The combined overlap metric may be used in the rules to adjust to position of a via to account for movement and sizing changes in a metal (e.g., from the drawn position of the metal).

In one or more embodiments, a second metric for via positioning may highlight the via-to-metal shorting risk. For example, a via may be proximal enough to two different metal lines that may cause an electrical short, and directly impacts yield and performance of a chip. The PAC-based via chasing method herein may use both the first metric and the second metric for via positioning.

In one or more embodiments, flexible design rules may be used for metal layers to remove the necessity of having fully populated metal tracks, and to help reduce undesirable capacitance increases within the layers, with the added benefit of making routing easier for tools. For layers with flexible design rules, the space between metal lines can have large variations and can be anything larger than a defined minimum value resulting in large, abrupt pitch transitions. The need to pattern many variations in pitches with a given optical source results in a reduced process window for the metal layers. OPC algorithms are utilized in the metal layers to enable improvement in the focus window at the patterning stage, but also result in sizing and shifting of the metal lines. The sizing and shifting of the metal lines can result in reduced via coverage and increased risk of via-metal shorts, thus reduce the integrated process window. The PAC-based via chasing method herein may maximize the via coverage and minimize risk of electrical shorts.

In one or more embodiments, the PAC-based via chasing methodology herein includes of the following sub-areas which will be discussed more below: (1) Rule-based algorithm that determines an approximate location for the metals after OPC and calculates how much the via needs to be moved to improve via-metal overlap and mitigate via-metal shorting risk. (2) Feedback of the shifted via positions to provide for improved OPC metrology when calculating Via to Metal overlap. (3) Metal LineEnd (e.g., ends of a metal lines) extension near Metal LineEnds to improve Combined Via coverage.

In one or more embodiments, the formula for a calculated via move is according to Equation (1):

$$move_i = \min\left(\frac{S_{2_i} - S_{1_i}}{4}, via\ enclosure\ budget, maximum\ shift\right) \qquad \text{Equation (1)},$$

where $S_{1_i}$ and $S_{2_i}$ are moves in an X-direction or Y-direction (e.g., respective to the drawn positions of metal lines), the *via enclosure budget* is an indication of the remaining distance from a via to a metal line end, and the *maximum shift* is a set limited value that limits the amount that the via may move from its drawn position. Movements in the X-direction and the Y-direction for the vias may be determined independently using Equation (1) based on metal above and metal below movements. If both Metal above and Metal below are moving to improve process window, the via would be shifted in a diagonal direction to account for both movements. If the shifted Via creates a Via patterning liability, the Via may be moved back to the drawn location as trading off a via liability to improve metal patterning violations may not be desirable.

In one or more embodiments, a sequence for PAC-based via chasing may include the following steps. First, metal lines that are expected to shift are identified based on rules, and a PAC identification layer (e.g., PAC ID) is placed over them in the Pre-OPC flow. The expected shifts in the PAC identified metal lines are calculated using Equation (1) above. The via shifts are determined based on the metal shifts, but also constrained based on via patterning requirements. For example, if the proposed shift brings two vias too close to each other and has high probability of creating a defect in the via mask, the vias are not shifted. The position of the shifted vias is available to the metal OPC flows to use in metrology and also enable the possibility of via-aware metal correction in specific locations if needed. The shifted vias are used for the via OPC flow to produce the via mask.

An alternate approach to via chasing is to create a single module OPC where both metal layers and the via layer are corrected together. However, the single module OPC approach may creates a complex multilayer OPC flow and may simultaneously link several metal and via layers together during tape-out processing, which will result in delays in mask availability. The enhanced approach herein avoids the complexity and delays while providing very similar accuracy to the single OPC approach.

Vias near metal line ends are particularly susceptible to via opens as the end of metal lines tend to be tapered. In one or more embodiments, in these cases, a custom solution may be applied to mitigate via opens. If there is room to extend the metal line end when vias are present near the line ends, then the metal line end may be extended to ensure an acceptable via to metal overlap.

In one or more embodiments, the via chasing herein improves all the key via-metal yield related metrics (e.g., the via opens and via to metal above and below shorting risks) as compared to the case when the metal and via corrections are not linked together as demonstrated in Table 1 below. As is shown in Table 1, both the magnitude of the overlap is improved for the via coverage check and via to metal above shorting check and is matched for via to metal below check. In all three checks, the quantity of sites not meeting the minimum overlap requirements is significantly reduced.

**Table 1: Post OPC Checks Using and Not Using PAC-Based Via Chasing:**

| Post OPC Check | No Via Chasing | PAC-Based Via Chasing |
|---|---|---|
| Via coverage/landing check (OPC model predicted area overlap) | 957 nm$^2$ (115k violations) | 982 nm$^2$ (21.2k violations) |
| Via shorting check (metal 1) | 12.7 nm (922 violations) | 13.2 nm (109 violations) |
| Via shorting check (metal 2) | 31.1 nm (181k violations) | 31.1 nm (179k violations) |

As shown in Table 1, simulated improvements using the PAC-based via chasing described herein reduces criteria violations in the chip manufacturing process for various post-OPC evaluations, and increases the overlap of metal and vias with respect to techniques that do not use PAC-based via chasing.

The above descriptions are for purposes of illustration and are not meant to be limiting. Numerous other examples, configurations, processes, algorithms, etc., may exist, some of which are described in greater detail below. Example embodiments will now be described with reference to the accompanying figures.

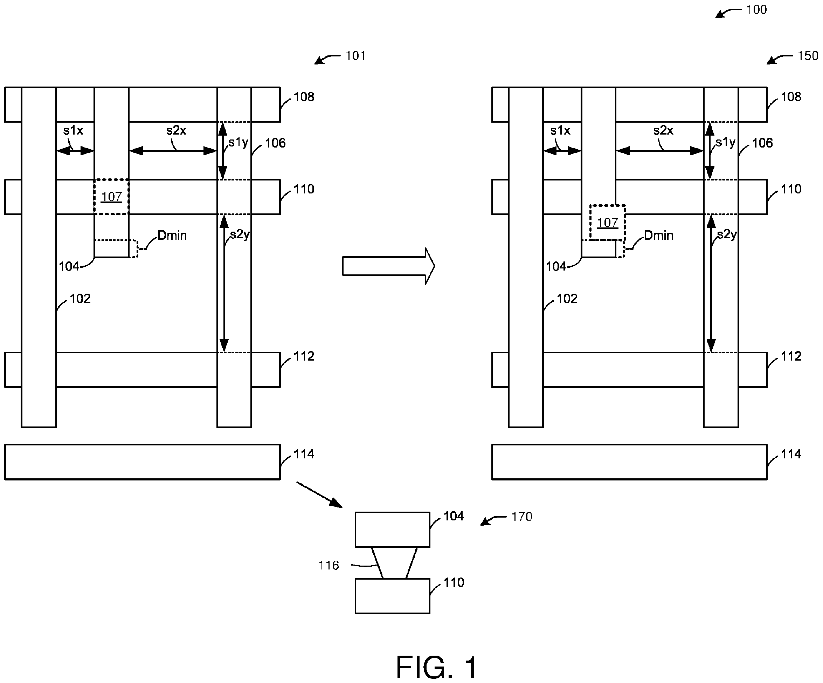

FIG. 1 is an example schematic drawing of optical proximity corrections (OPC) to determine placement of vias in a computer chip 100, according to some example embodiments of the present disclosure.

Referring to FIG. 1, at a first step 101, a metal line 102, a metal line 104, and a metal line 106 are shown as above (e.g., coming out of the page) a via 107, and a metal line 108, a metal line 110, a metal line 112, and a metal line 114 of the computer chip 100 are shown as below (e.g., going into the page) the via 107 of the computer chip 100. A distance s1x may represent a distance between the metal line 102 and the metal line 104, and a distance s2x may represent a distance between the metal line 104 and the metal line 106 at step 101. A distance s1y may represent a distance between the metal line 108 and the metal line 110, and a distance s2y may represent a distance between the metal line 110 and the metal line 112 at step 101.

Still referring to FIG. 1, the position of the via 107 may shift (e.g., with respect to step 101) based on predicted shifting of the metal lines from step 101. The calculation of the shift in position of the via 107 may be based on Equation (1) above, where $S_{2_i} - S_{1_i}$ can be in both X and Y directions (e.g., $S_{2_x} - S_{1_x}$ in the X direction, and $S_{2_y} - S_{1_y}$ in the Y direction). As shown at step 150, the shift of the via 107 position may be limited by a maximum shift and by the distance Dmin (e.g., corresponding to the *Via Enclosure Budget* of Equation (1)).

In one or more embodiments, the Dmin may represent a constraint placed on the via 107 movement to not violate a via-metal LineEnd enclosure (e.g., a minimum distance that needs to be maintained between the via 107 and the metal LineEnd per design rules). This is because metals may taper near the LineEnds, and moving the via 107 closer to the lineEnd may result in small via areas that would be difficult to fill in with a self-aligned via process.

In one or more embodiments, X and Y movements for the via 107 may be independently determined based on Metal above (e.g., the metal lines 102-106) and metal below (e.g., the metal lines 108-114) movements. If both metal above and metal below are moving to improve a process window, the via 107 would be shifted in a diagonal direction to account for both movements.

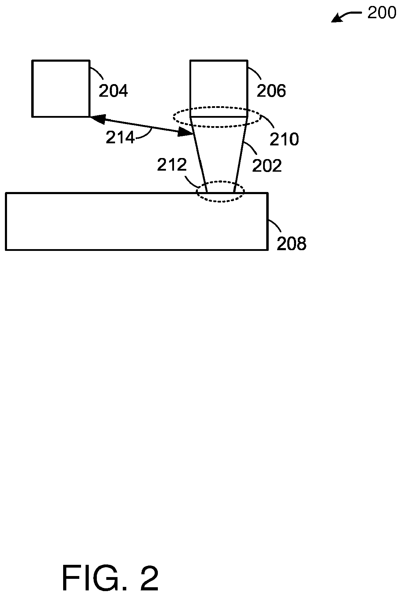

FIG. 2 illustrates example an example schematic drawing of metrics for determining the placement of vias in a computer chip 200 in OPC, in accordance with one or more example embodiments of the present disclosure.

Referring to FIG. 2, the computer chip 200 may include a via 202 in between a metal line 204 and a metal line 206 above the via 202 and a metal line 208 below the via 202. A via coverage metric may refer to an amount of the via overlapped by a metal line. The enhanced via chasing method herein may use a combined via coverage metric, which is a combined overlap of an area 210 of the via 202 overlapped by the metal line 206 and an area 212 of the via 202 overlapped by the metal line 208 (e.g., a combined overlap of the via 202 with the metal above and the metal below).

Still referring to FIG. 2, a second metric may be a via-to-metal electrical shorting risk 214 (e.g., the risk of the via 202 creating a connection with an unintended metal line such as the metal line 204) by shifting too close to the unintended metal line. This risk is relevant for Via-Metal Above as well as Via to Metal Below and directly impacts yield and performance of the computer chip 200.

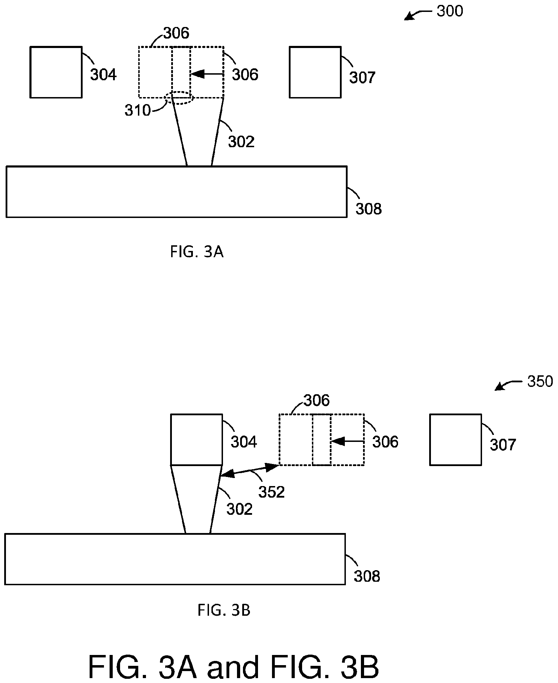

Some process nodes may use "flexible" design rules for metal layers to remove the necessity of having fully populated metal tracks and help reduce undesirable capacitance increase within the layers with the added benefit of making routing easier for industry tools. For layers with "flexible" design rules, the space between metal lines can have large variations and can be anything larger than a defined minimum value resulting in large, abrupt pitch transitions. The need to pattern many variations in pitches with a given optical source results in reduced process window for the metal layers. OPC algorithms are utilized in the metal layers that enable the much needed improvement in the focus window at the patterning stage, but also result in sizing and shifting of the metal lines. This sizing and shifting of the metal lines can result in reduced via coverage and increased risk of Via-metal shorts thus reduce the integrated process window (e.g., as shown in FIG. 3A and FIG. 3B).

FIG. 3A illustrates example via overlap in a computer chip 300 in OPC, in accordance with one or more example embodiments of the present disclosure.

Referring to FIG. 3A, the computer chip 300 may include a via 302 in between metal above (e.g., metal line 304, metal line 306, metal line 307) and metal below (e.g., metal line 308). As shown in FIG. 3A, a location shift of the metal line 306 may result in reduced via coverage (e.g., overlap with the via 302).

FIG. 3B illustrates example electrical shorting risk in a computer chip 350 in OPC, in accordance with one or more example embodiments of the present disclosure.

Referring to FIG. 3B, the computer chip 300 may include the via 302 in between metal above (e.g., the metal line 304, the metal line 306, the metal line 307) and metal below (e.g., the metal line 308). As shown in FIG. 3B, as the metal line 306 shifts toward the via 302, an electrical shorting risk 352 may increase.

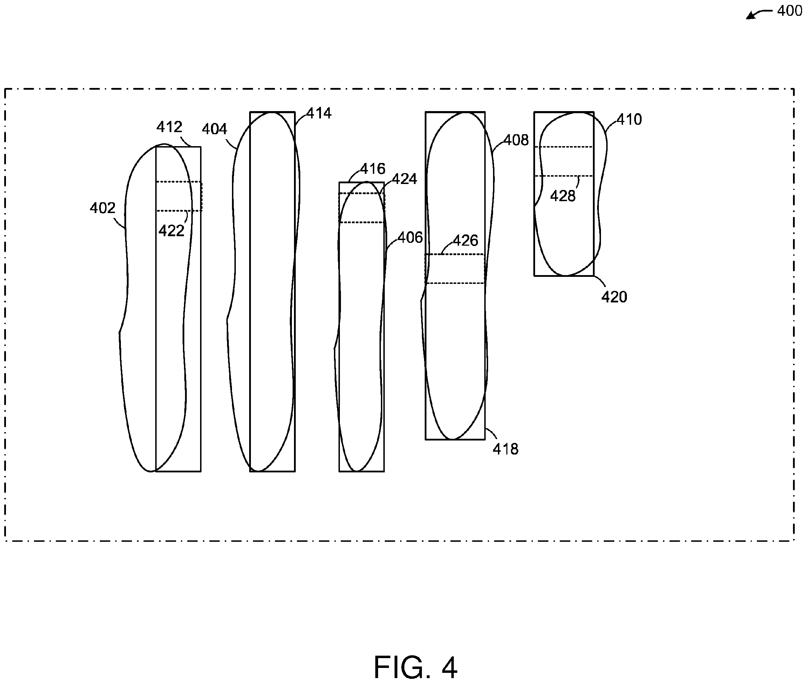

FIG. 4 illustrates an example scanning electron microscope (SEM) image 400 of a computer chip in OPC for determining the placement of vias, in accordance with one or more example embodiments of the present disclosure.

Referring to FIG. 4, the SEM image 400 may include via 402, via 404, via 406, via 408, and via 410 (e.g., of a computer chip). Based on the vias, metal-drawn polygons for metal lines may be drawn (e.g., metal-drawn polygon 412 for the via 402, metal-drawn polygon 414 for the via 404, metal-drawn polygon 416 for the via 406, metal-drawn polygon 418 for the via 408, metal-drawn polygon 420 for the via 410). Drawn vias also are shown (e.g., via 422, via 424, via 426, and via 428). FIG. 4 demonstrates a significant shift as a function of metal lines, and how the via-to-metal overlap may be reduced as the metal lines shift.

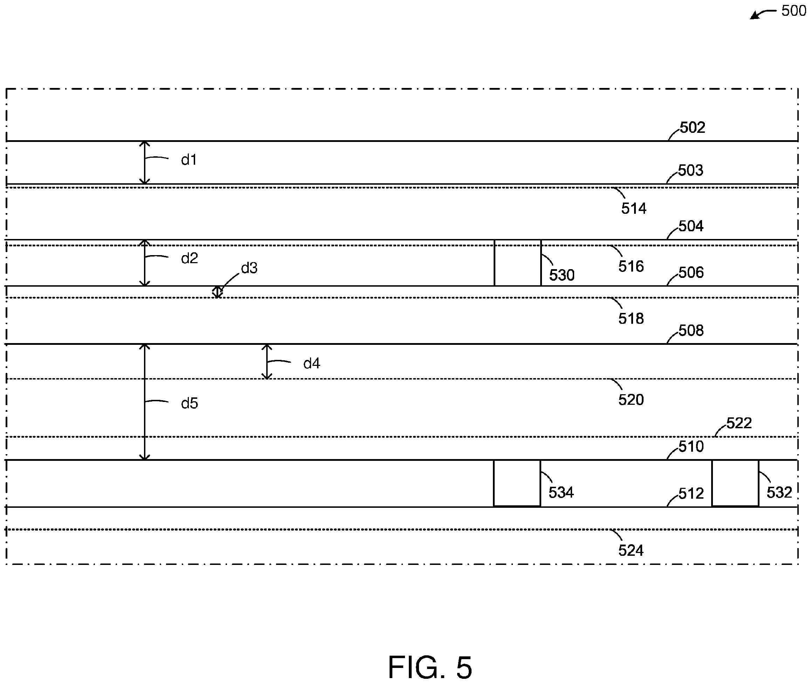

FIG. 5 illustrates an example schematic drawing of a computer chip 500 in OPC for determining placement of vias, in accordance with one or more example embodiments of the present disclosure.

Referring to FIG. 5, the computer chip 500 may include drawn metal lines (e.g., metal line 502, metal line 503, metal line 504, metal line 506, metal line 508, metal line 510, and metal line 512), predicted OPC contour predictions of shifts of the metal lines (e.g., shifted metal line 514, shifted metal line 516, shifted metal line 518, shifted metal line 520, shifted metal line 522, and shifted metal line 524), and drawn vias (e.g., via 530, via 532, and via 534).

Still referring to FIG. 5, a distance d1 may be a distance between the metal line 502 and the metal line 503. A distance d2 may be a distance between the metal line 504 and the metal line 506. A distance d3 may be a distance between the metal line 506 and he shifted metal line 518. A distance d4 may be a distance between the metal line 508 and the shifted metal line 520. A distance d5 may be a distance between the metal line 508 and the metal line 510. As shown in FIG. 5, the shift of the metal lines may occur in regions where there is a transition in space from nested metal lines to isolated or semi-isolated lines. Metal lines between unequal spaces tend to shift towards the larger space as shown by the OPC contour predictions. Based on this, Equation (1) may be used to determine the shifted position of a via during OPC.

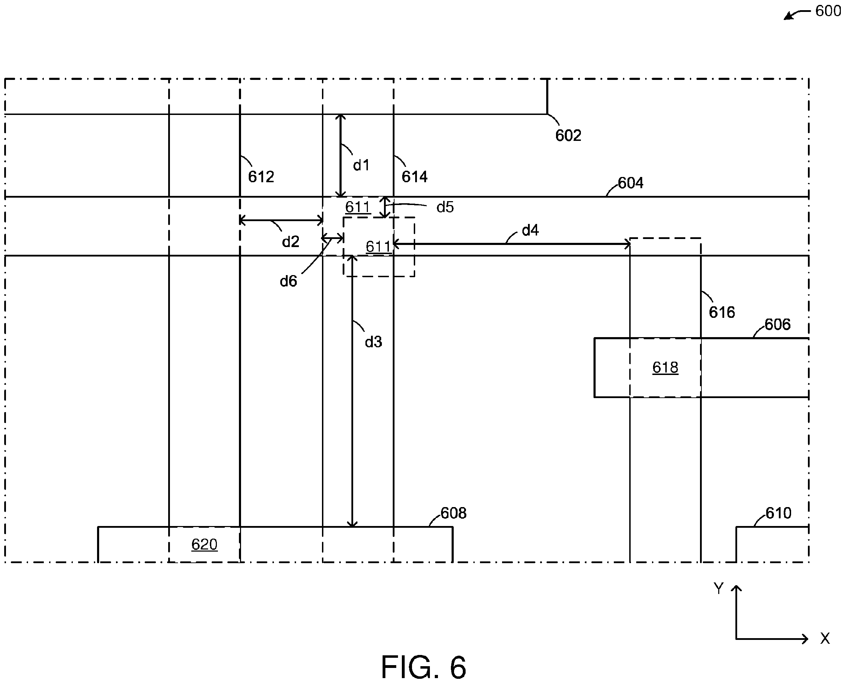

FIG. 6 illustrates an example schematic drawing of a computer chip 600 in OPC for determining placement of vias, in accordance with one or more example embodiments of the present disclosure. In particular, FIG. 6 shows a top-down view of the metal above and below a via.

Referring to FIG. 6, the computer chip 600 may include metal above (e.g., metal line 602, metal line 604, metal line 606, metal line 608, and metal line 610, above a via 611 - coming out of the page), and metal below (e.g., metal line 612, metal line 614, and metal line 616, below the via 611 - going into the page). The via 611, via 618, and via 620 are shown as drawn vias for OPC. A shift to the via 611 is shown in FIG. 6, and may be calculated by Equation (1) above, based on distances between the metal lines (e.g., distance d1 between the metal line 602 and the metal line 604, distance d2 between the metal line 612 and the metal line 614, distance d3 between the metal line 604 and the metal line 608, and distance d4 between the metal line 614 and the metal line 616. Distance d5 may be the maximum shift allowed for the via 611 in the Y direction, and distance d6 may be the maximum shift allowed for the via 611 in the X direction. For example, for *move$_x$* of Equation (1) applied to FIG. 6 may be represented as:

$$move_x = \min\left(\frac{d4-d2}{4}, d6\right),$$

and *move$_y$* of Equation (1) applied to FIG. 6 may be represented as:

$$move_y = \min\left(\frac{d3-d1}{4}, d5\right).$$

Still referring to FIG. 6, the via 611 shifts in both the X and Y directions (e.g., diagonally). If the shifted via 611 creates a via patterning liability, it is moved back to the drawn location as trading off a via liability to improve metal patterning violations is not desirable.

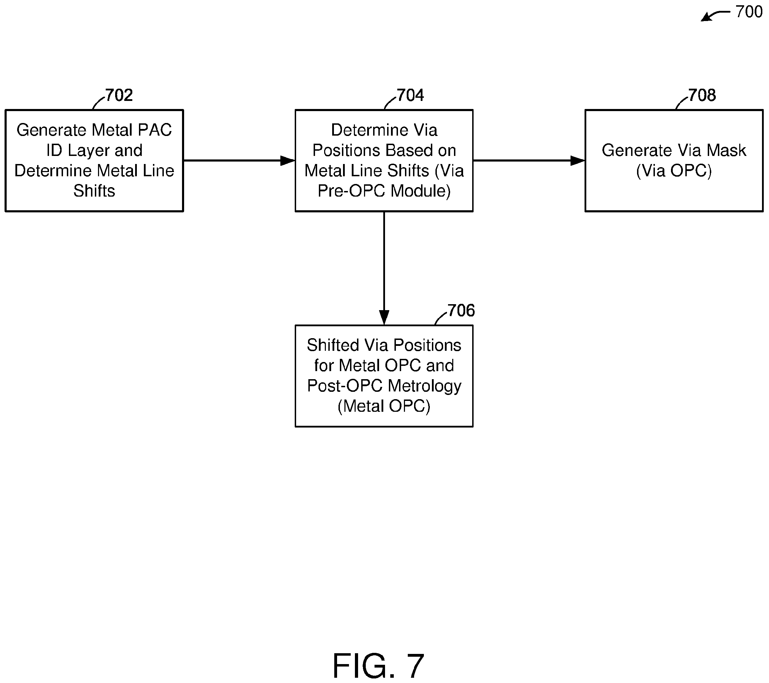

FIG. 7 illustrates a flow diagram of an illustrative process 700 for determining the placement of vias in a computer chip in OPC, in accordance with one or more example embodiments of the present disclosure.

Referring to FIG. 7, at block 702, a metal PAC identifier (ID) layer may be generated and the metal line shifts may be calculated. At block 704, using a pre-OPC module, via positions may be calculated based on metal line shifts (e.g., using Equation (1) above). The via shifts may be implemented if via pattern requirements are met, or vias may remain at their drawn positions if not. At block 706, at metal OPC, the shifted via positions may be made available to the metal OPC and post-OPC metrology. At block 708, a layout for generating the via mask may be generated at the via OPC. The via mask may be used for the fabrication process.

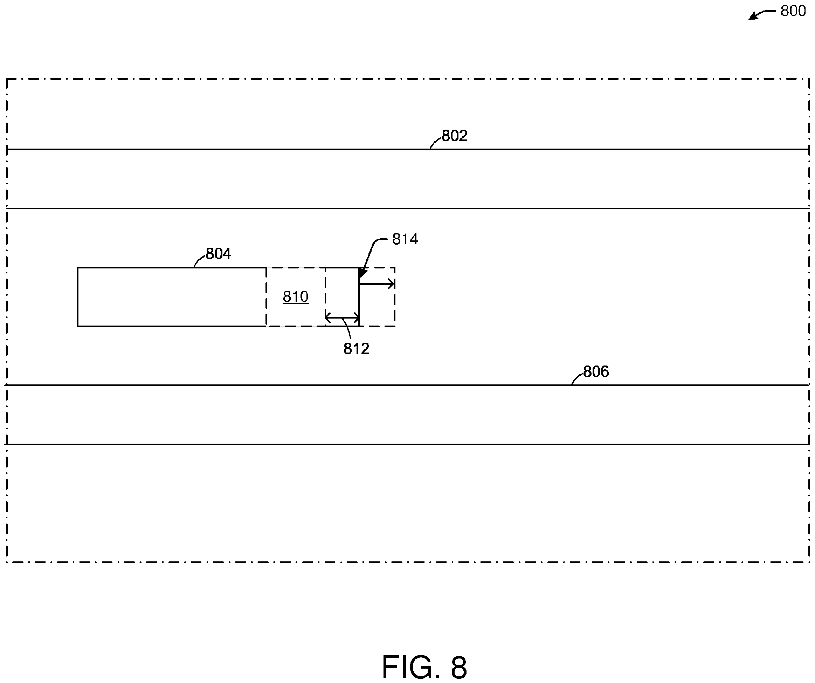

FIG. 8 illustrates an example schematic for extending a metal line of a computer chip 800 in OPC when determining the placement of vias, in accordance with one or more example embodiments of the present disclosure.

Referring to FIG. 8, the computer chip 800 may include a metal line 802, a metal line 804, a metal line 806, and a via 810. As shown, the via 810 may be a distance 812 from a line end 814 of the metal line 804. The line end 814 of the metal line 804 may be extended (e.g., extending the metal line 804) when there is room for the extension and when the distance 812 is less than a threshold distance, allowing an acceptable via-to-metal overlap.

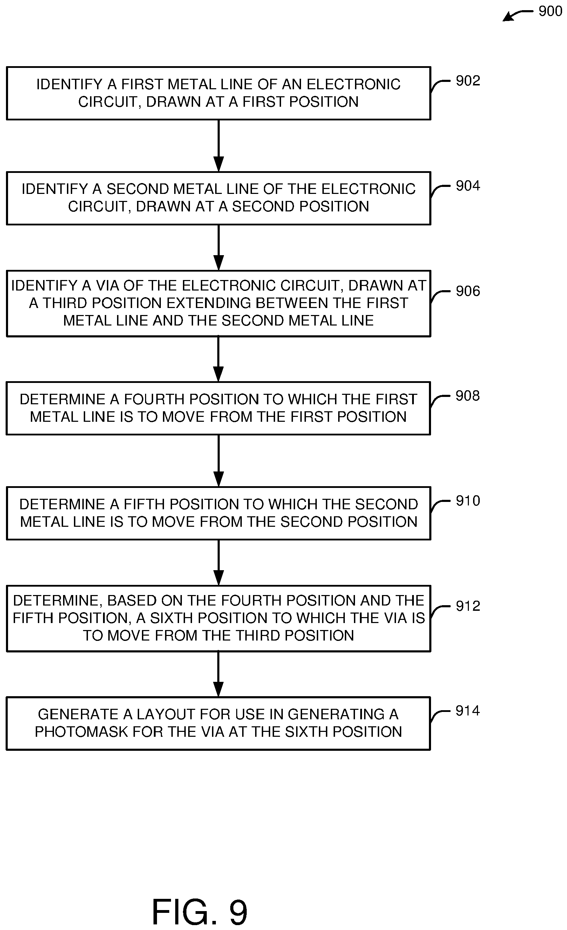

FIG. 9 illustrates a flow diagram of an illustrative process 900 for determining the placement of vias in a computer chip in OPC, in accordance with one or more example embodiments of the present disclosure.

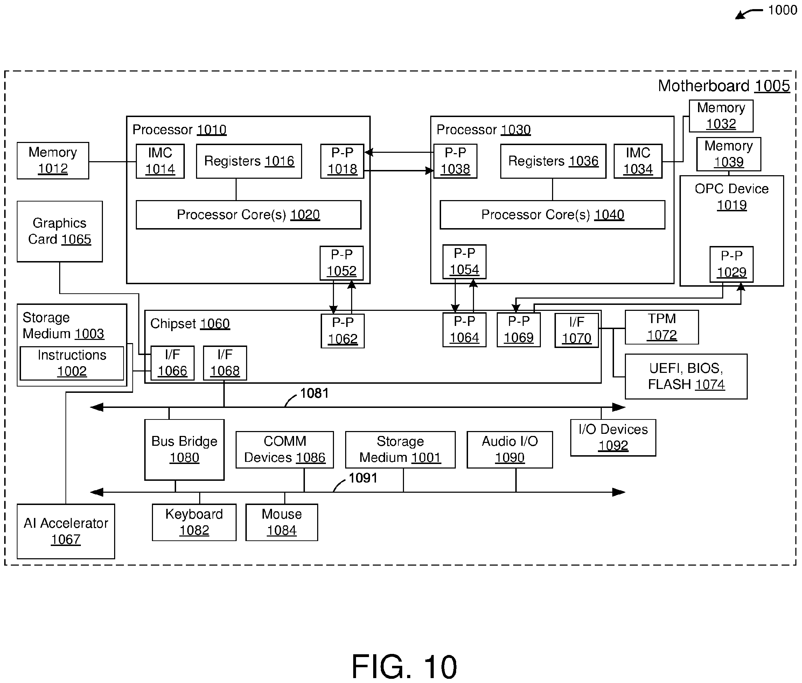

At block 902, a device (or system or apparatus, e.g., the OPC device 1019 of FIG. 10) may identify a first metal line of an electronic circuit, drawn at a first position.

At block 904, the device may identify a second metal line of the electronic circuit, drawn at a second position.

At block 906, the device may identify a via of the electronic circuit, drawn at a third position, extending between the first metal line and the second metal line.

At block 908, the device may determine a fourth position to which the first metal line is to move from the first position (e.g., using a PAC based formula).

At block 910, the device may determine a fifth position to which the second metal line is to move from the second position (e.g., using the PAC based formula).

At block 912, the device may determine, based on the fourth and fifth positions (e.g., using Equation (1)), a sixth position to which the via is to move from the third position.

A block 914, the device may generate a photomask for the via at the sixth position.

It is understood that the above descriptions are for purposes of illustration and are not meant to be limiting.

FIG. 10 illustrates an embodiment of an exemplary system 1000, in accordance with one or more example embodiments of the present disclosure.

In various embodiments, the computing system 1000 may comprise or be implemented as part of an electronic device.

In some embodiments, the computing system 1000 may be representative, for example, of a computer system that implements one or more components and/or performs steps of the processes of FIGs. 1-9.

The embodiments are not limited in this context. More generally, the computing system 1000 is configured to implement all logic, systems, processes, logic flows, methods, equations, apparatuses, and functionality described herein and with reference to FIGS. 1-9.

The system 1000 may be a computer system with multiple processor cores such as a distributed computing system, supercomputer, high-performance computing system, computing cluster, mainframe computer, mini-computer, client-server system, personal computer (PC), workstation, server, portable computer, laptop computer, tablet computer, a handheld device such as a personal digital assistant (PDA), or other devices for processing, displaying, or transmitting information. Similar embodiments may comprise, e.g., entertainment devices such as a portable music player or a portable video player, a smart phone or other cellular phones, a telephone, a digital video camera, a digital still camera, an external storage device, or the like. Further embodiments implement larger scale server configurations. In other embodiments, the system 1000 may have a single processor with one core or more than one processor. Note that the term "processor" refers to a processor with a single core or a processor package with multiple processor cores.

In at least one embodiment, the computing system 1000 is configured to implement all logic, systems, processes, logic flows, methods, apparatuses, and functionality described herein with reference to the above figures.

As used in this application, the terms "system" and "component" and "module" are intended to refer to a computer-related entity, either hardware, a combination of hardware and software, software, or software in execution, examples of which are provided by the exemplary system 1000. For example, a component can be, but is not limited to being, a process running on a processor, a processor, a hard disk drive, multiple storage drives (of optical and/or magnetic storage medium), an object, an executable, a thread of execution, a program, and/or a computer.

By way of illustration, both an application running on a server and the server can be a component. One or more components can reside within a process and/or thread of execution, and a component can be localized on one computer and/or distributed between two or more computers. Further, components may be communicatively coupled to each other by various types of communications media to coordinate operations. The coordination may involve the uni-directional or bi-directional exchange of information. For instance, the components may communicate information in the form of signals communicated over the communications media. The information can be implemented as signals allocated to various signal lines. In such allocations, each message is a signal. Further embodiments, however, may alternatively employ data messages. Such data messages may be sent across various connections. Exemplary connections include parallel interfaces, serial interfaces, and bus interfaces.

As shown in this figure, system 1000 comprises a motherboard 1005 for mounting platform components. The motherboard 1005 is a point-to-point interconnect platform that includes a processor 1010, a processor 1030 coupled via a point-to-point interconnects as an Ultra Path Interconnect (UPI), and an OPC device 1019 (e.g., capable of performing the functions of FIGs. 1-9). In other embodiments, the system 1000 may be of another bus architecture, such as a multi-drop bus. Furthermore, each of processors 1010 and 1030 may be processor packages with multiple processor cores. As an example, processors 1010 and 1030 are shown to include processor core(s) 1020 and 1040, respectively. While the system 1000 is an example of a two-socket (2S) platform, other embodiments may include more than two sockets or one socket. For example, some embodiments may include a four-socket (4S) platform or an eight-socket (8S) platform. Each socket is a mount for a processor and may have a socket identifier. Note that the term platform refers to the motherboard with certain components mounted such as the processors 1010 and the chipset 1060. Some platforms may include additional components and some platforms may only include sockets to mount the processors and/or the chipset.

The processors 1010 and 1030 can be any of various commercially available processors, including without limitation an Intel® Celeron®, Core®, Core (2) Duo®, Itanium®, Pentium®, Xeon®, and XScale® processors; AMD® Athlon®, Duron® and Opteron® processors; ARM® application, embedded and secure processors; IBM® and Motorola® Dragon-Ball® and PowerPC® processors; IBM and Sony® Cell processors; and similar processors. Dual microprocessors, multi-core processors, and other multi-processor architectures may also be employed as the processors 1010, and 1030.

The processor 1010 includes an integrated memory controller (IMC) 1014 and point-to-point (P-P) interfaces 1018 and 1052. Similarly, the processor 1030 includes an IMC 1034 and P-P interfaces 1038 and 1054. The IMC's 1014 and 1034 couple the processors 1010 and 1030, respectively, to respective memories, a memory 1012 and a memory 1032. The memories 1012 and 1032 may be portions of the main memory (e.g., a dynamic random-access memory (DRAM)) for the platform such as double data rate type 3 (DDR3) or type 4 (DDR4) synchronous DRAM (SDRAM). In the present embodiment, the memories 1012 and 1032 locally attach to the respective processors 1010 and 1030.

In addition to the processors 1010 and 1030, the system 1000 may include the OPC device 1019. The OPC device 1019 may be connected to chipset 1060 by means of P-P interfaces 1029 and 1069. The OPC device 1019 may also be connected to a memory 1039. In some embodiments, the OPC device 1019 may be connected to at least one of the processors 1010 and 1030. In other embodiments, the memories 1012, 1032, and 1039 may couple with the processor 1010 and 1030, and the OPC device 1019 via a bus and shared memory hub.

System 1000 includes chipset 1060 coupled to processors 1010 and 1030. Furthermore, chipset 1060 can be coupled to storage medium 1003, for example, via an interface (I/F) 1066. The I/F 1066 may be, for example, a Peripheral Component Interconnect- enhanced (PCI-e). The processors 1010, 1030, and the OPC device 1019 may access the storage medium 1003 through chipset 1060.

Storage medium 1003 may comprise any non-transitory computer-readable storage medium or machine- readable storage medium, such as an optical, magnetic or semiconductor storage medium. In various embodiments, storage medium 1003 may comprise an article of manufacture. In some embodiments, storage medium 603 may store computer-executable instructions, such as computer-executable instructions 1002 to implement one or more of processes or operations described herein, (e.g., process 900 of FIG. 9). The storage medium 1003 may store computer-executable instructions for any equations depicted above. The storage medium 1003 may further store computer-executable instructions for models and/or networks described herein, such as a neural network or the like. Examples of a computer-readable storage medium or machine-readable storage medium may include any tangible media capable of storing electronic data, including volatile memory or non-volatile memory, removable or non-removable memory, erasable or non-erasable memory, writeable or re-writeable memory, and so forth. Examples of computer-executable instructions may include any suitable types of code, such as source code, compiled code, interpreted code, executable code, static code, dynamic code, object-oriented code, visual code, and the like. It should be understood that the embodiments are not limited in this context.

The processor 1010 couples to a chipset 1060 via P-P interfaces 1052 and 1062 and the processor 1030 couples to a chipset 1060 via P-P interfaces 1054 and 1064. Direct Media Interfaces (DMIs) may couple the P-P interfaces 1052 and 1062 and the P-P interfaces 1054 and 1064, respectively. The DMI may be a highspeed interconnect that facilitates, e.g., eight Giga Transfers per second (GT/s) such as DMI 3.0. In other embodiments, the processors 1010 and 1030 may interconnect via a bus.

The chipset 1060 may comprise a controller hub such as a platform controller hub (PCH). The chipset 1060 may include a system clock to perform clocking functions and include interfaces for an I/O bus such as a universal serial bus (USB), peripheral component interconnects (PCIs), serial peripheral interconnects (SPIs), integrated interconnects (I2Cs), and the like, to facilitate connection of peripheral devices on the platform. In other embodiments, the chipset 1060 may comprise more than one controller hub such as a chipset with a memory controller hub, a graphics controller hub, and an input/output (I/O) controller hub.

In the present embodiment, the chipset 1060 couples with a trusted platform module (TPM) 1072 and the UEFI, BIOS, Flash component 1074 via an interface (I/F) 1070. The TPM 1072 is a dedicated microcontroller designed to secure hardware by integrating cryptographic keys into devices. The UEFI, BIOS, Flash component 1074 may provide pre-boot code.

Furthermore, chipset 1060 includes the I/F 1066 to couple chipset 1060 with a high-performance graphics engine, graphics card 1065. In other embodiments, the system 1000 may include a flexible display interface (FDI) between the processors 1010 and 1030 and the chipset 1060. The FDI interconnects a graphics processor core in a processor with the chipset 1060.

Various I/O devices 1092 couple to the bus 1081, along with a bus bridge 1080 which couples the bus 1081 to a second bus 1091 and an I/F 1068 that connects the bus 1081 with the chipset 1060. In one embodiment, the second bus 1091 may be a low pin count (LPC) bus. Various devices may couple to the second bus 1091 including, for example, a keyboard 1082, a mouse 1084, communication devices 1086, a storage medium 1001, and an audio I/O 1090 (e.g., including one or more microphones).

The artificial intelligence (AI) accelerator 1067 may be circuitry arranged to perform computations related to AI. The AI accelerator 1067 may be connected to storage medium 1003 and chipset 1060. The AI accelerator 1067 may deliver the processing power and energy efficiency needed to enable abundant-data computing. The AI accelerator 1067 is a class of specialized hardware accelerators or computer systems designed to accelerate artificial intelligence and machine learning applications, including artificial neural networks andmachine vision. The AI accelerator 1067 may be applicable to algorithms for robotics, internet of things, other data-intensive and/or sensor-driven tasks.

Many of the I/O devices 1092, communication devices 1086, and the storage medium 1001 may reside on the motherboard 1005 while the keyboard 1082 and the mouse 1084 may be add-on peripherals. In other embodiments, some or all the I/O devices 1092, communication devices 1086, and the storage medium 1001 are add-on peripherals and do not reside on the motherboard 1005.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, yet still co-operate or interact with each other.

In addition, in the foregoing Detailed Description, various features are grouped together in a single example to streamline the disclosure. This method of disclosure is not to be interpreted as reflecting an intention that the claimed examples require more features than are expressly recited in each claim. Rather, as the following claims reflect, the inventive subject matter lies in less than all features of a single disclosed example. Thus, the following claims are hereby incorporated into the Detailed Description, with each claim standing on its own as a separate example. In the appended claims, the terms "including" and "in which" are used as the plain-English equivalents of the respective terms "comprising" and "wherein," respectively. Moreover, the terms "first," "second," "third," and so forth, are used merely as labels and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

A data processing system suitable for storing and/or executing program code will include at least one processor coupled directly or indirectly to memory elements through a system bus. The memory elements can include local memory employed during actual execution of the program code, bulk storage, and cache memories that provide temporary storage of at least some program code to reduce the number of times code must be retrieved from bulk storage during execution. The term "code" covers a broad range of software components and constructs, including applications, drivers, processes, routines, methods, modules, firmware, microcode, and subprograms. Thus, the term "code" may be used to refer to any collection of instructions that, when executed by a processing system, perform a desired operation or operations.

Logic circuitry, devices, and interfaces herein described may perform functions implemented in hardware and implemented with code executed on one or more processors. Logic circuitry refers to the hardware or the hardware and code that implements one or more logical functions. Circuitry is hardware and may refer to one or more circuits. Each circuit may perform a particular function. A circuit of the circuitry may comprise discrete electrical components interconnected with one or more conductors, an integrated circuit, a chip package, a chipset, memory, or the like. Integrated circuits include circuits created on a substrate such as a silicon wafer and may comprise components. Integrated circuits, processor packages, chip packages, and chipsets may comprise one or more processors.

Processors may receive signals such as instructions and/or data at the input(s) and process the signals to generate at least one output. While executing code, the code changes the physical states and characteristics of transistors that make up a processor pipeline. The physical states of the transistors translate into logical bits of ones and zeros stored in registers within the processor. The processor can transfer the physical states of the transistors into registers and transfer the physical states of the transistors to another storage medium.

A processor may comprise circuits to perform one or more sub-functions implemented to perform the overall function of the processor. One example of a processor is a state machine or an application-specific integrated circuit (ASIC) that includes at least one input and at least one output. A state machine may manipulate the at least one input to generate the at least one output by performing a predetermined series of serial and/or parallel manipulations or transformations on the at least one input.

The logic as described above may be part of the design for an integrated circuit chip. The chip design is created in a graphical computer programming language, and stored in a computer storage medium or data storage medium (such as a disk, tape, physical hard drive, or virtual hard drive such as in a storage access network). If the designer does not fabricate chips or the photolithographic masks used to fabricate chips, the designer transmits the resulting design by physical means (e.g., by providing a copy of the storage medium storing the design) or electronically (e.g., through the Internet) to such entities, directly or indirectly. The stored design is then converted into the appropriate format (e.g., GDSII) for the fabrication.

The resulting integrated circuit chips can be distributed by the fabricator in raw wafer form (that is, as a single wafer that has multiple unpackaged chips), as a bare die, or in a packaged form. In the latter case, the chip is mounted in a single chip package (such as a plastic carrier, with leads that are affixed to a motherboard or other higher-level carrier) or in a multichip package (such as a ceramic carrier that has either or both surface interconnections or buried interconnections). In any case, the chip is then integrated with other chips, discrete circuit elements, and/or other signal processing devices as part of either (a) an intermediate product, such as a processor board, a server platform, or a motherboard, or (b) an end product.

The word "exemplary" is used herein to mean "serving as an example, instance, or illustration." Any embodiment described herein as "exemplary" is not necessarily to be construed as preferred or advantageous over other embodiments. The terms "computing device," "user device," "communication station," "station," "handheld device," "mobile device," "wireless device" and "user equipment" (LTE) as used herein refers to a wireless communication device such as a cellular telephone, a smartphone, a tablet, a netbook, a wireless terminal, a laptop computer, a femtocell, a high data rate (HDR) subscriber station, an access point, a printer, a point of sale device, an access terminal, or other personal communication system (PCS) device. The device may be either mobile or stationary.

As used within this document, the term "communicate" is intended to include transmitting, or receiving, or both transmitting and receiving. This may be particularly useful in claims when describing the organization of data that is being transmitted by one device and received by another, but only the functionality of one of those devices is required to infringe the claim. Similarly, the bidirectional exchange of data between two devices (both devices transmit and receive during the exchange) may be described as "communicating," when only the functionality of one of those devices is being claimed. The term "communicating" as used herein with respect to a wireless communication signal includes transmitting the wireless communication signal and/or receiving the wireless communication signal. For example, a wireless communication unit, which is capable of communicating a wireless communication signal, may include a wireless transmitter to transmit the wireless communication signal to at least one other wireless communication unit, and/or a wireless communication receiver to receive the wireless communication signal from at least one other wireless communication unit.

As used herein, unless otherwise specified, the use of the ordinal adjectives "first," "second," "third," etc., to describe a common object, merely indicates that different instances of like objects are being referred to and are not intended to imply that the objects so described must be in a given sequence, either temporally, spatially, in ranking, or in any other manner.

Some embodiments may be used in conjunction with various devices and systems, for example, a personal computer (PC), a desktop computer, a mobile computer, a laptop computer, a notebook computer, a tablet computer, a server computer, a handheld computer, a handheld device, a personal digital assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless access point (AP), a wired or wireless router, a wired or wireless modem, a video device, an audio device, an audio-video (A/V) device, a wired or wireless network, a wireless area network, a wireless video area network (WVAN), a local area network (LAN), a wireless LAN (WLAN), a personal area network (PAN), a wireless PAN (WPAN), and the like.

Some embodiments may be used in conjunction with one way and/or two-way radio communication systems, cellular radio-telephone communication systems, a mobile phone, a cellular telephone, a wireless telephone, a personal communication system (PCS) device, a PDA device which incorporates a wireless communication device, a mobile or portable global positioning system (GPS) device, a device which incorporates a GPS receiver or transceiver or chip, a device which incorporates an RFID element or chip, a multiple input multiple output (MIMO) transceiver or device, a single input multiple output (SIMO) transceiver or device, a multiple input single output (MISO) transceiver or device, a device having one or more internal antennas and/or external antennas, digital video broadcast (DVB) devices or systems, multi-standard radio devices or systems, a wired or wireless handheld device, e.g., a smartphone, a wireless application protocol (WAP) device, or the like.

Some embodiments may be used in conjunction with one or more types of wireless communication signals and/or systems following one or more wireless communication protocols, for example, radio frequency (RF), infrared (IR), frequency-division multiplexing (FDM), orthogonal FDM (OFDM), time-division multiplexing (TDM), time-division multiple access (TDMA), extended TDMA (E-TDMA), general packet radio service (GPRS), extended GPRS, code-division multiple access (CDMA), wideband CDMA (WCDMA), CDMA 2000, single-carrier CDMA, multi-carrier CDMA, multi-carrier modulation (MDM), discrete multi-tone (DMT), Bluetooth®, global positioning system (GPS), Wi-Fi, Wi-Max, ZigBee, ultra-wideband (UWB), global system for mobile communications (GSM), 2G, 2.5G, 3G, 3.5G, 4G, fifth generation (5G) mobile networks, 3GPP, long term evolution (LTE), LTE advanced, enhanced data rates for GSM Evolution (EDGE), or the like. Other embodiments may be used in various other devices, systems, and/or networks.

The following examples pertain to further embodiments.

Example 1 may include a method for shifting layouts of electronic circuit vias during optical proximity corrections (OPC), the method comprising: identifying a first metal line, of an electronic circuit, drawn at a first position; identifying a second metal line, of the electronic circuit, drawn at a second position; identifying a via, of the electronic circuit, drawn at a third position extending between the first metal line and the second metal line; determining a fourth position to which the first metal line is to move from the first position; determining a fifth position to which the second metal line is to move from the second position; determining, based on the fourth position and the fifth position, a sixth position to which the via is to move from third position; and generating a photomask for the via at the sixth position.

Example 2 may include the method of example 1 and/or any other example herein, further comprising: determining, based on the first position, a first distance between the first metal line at the fourth position and a third metal line of the electronic circuit; and determining, based on the first position, a second distance between the first metal line at the fourth position and a fourth metal line of the electronic circuit, wherein determining the sixth position is further based on the first distance and the second distance.

Example 3 may include the method of example 2 and/or any other example herein, further comprising: determining a difference between the first distance and the second distance; and determining a minimum of the difference and a variable indicative of an amount of allowed movement of the via from the third position, wherein determining the sixth position is further based on the minimum.

Example 4 may include the method of example 3 and/or any other example herein, further comprising: determining, based on the second position, a third distance between the second metal line at the second position and a fifth metal line of the electronic circuit; and determining, based on the second position, a fourth distance between the second metal line at the second position and a sixth metal line of the electronic circuit, wherein determining the sixth position is further based on the third distance and the fourth distance.

Example 5 may include the method of example 4 and/or any other example herein, further comprising: determining a second difference between the third distance and the fourth distance; and determining a second minimum of the second distance and the variable, wherein determining the sixth position is further based on the second minimum.

Example 6 may include the method of example 5 and/or any other example herein, wherein movement of the via from the third position to the sixth position comprises a first direction movement and a second direction movement.

Example 7 may include the method of example 1 and/or any other example herein, wherein determining the fourth position and determining the fifth position are based on a pitch awareness correction identification layer.

Example 8 may include the method of example 1 and/or any other example herein, further comprising: determining that the sixth position is within a distance from an edge of the first metal line at the fourth position; and extending the edge of the first metal line at the fourth position based on the determination that the sixth position is within the distance from the edge of the first metal line at the fourth position.

Example 9 may include a device for shifting layouts of electronic circuit vias during optical proximity corrections (OPC), the device comprising at least one processor coupled to memory storing instructions that, when executed by the at least one processor, causes the device to: identify a first metal line, of an electronic circuit, drawn at a first position; identify a second metal line, of the electronic circuit, drawn at a second position; identify a via, of the electronic circuit, drawn at a third position extending between the first metal line and the second metal line; determine a fourth position to which the first metal line is to move from the first position; determine a fifth position to which the second metal line is to move from the second position; determine, based on the fourth position and the fifth position, a sixth position to which the via is to move from third position; and generate a photomask for the via at the sixth position.

Example 10 may include the device of example 9 and/or any other example herein, wherein the at least one processor is further configured to: determine, based on the first position, a first distance between the first metal line at the fourth position and a third metal line of the electronic circuit; and determine, based on the first position, a second distance between the first metal line at the fourth position and a fourth metal line of the electronic circuit, wherein to determine the sixth position is further based on the first distance and the second distance.

Example 11 may include the device of example 10 and/or any other example herein, wherein the at least one processor is further configured to: determine a difference between the first distance and the second distance; and determine a minimum of the difference and a variable indicative of an amount of allowed movement of the via from the third position, wherein to determine the sixth position is further based on the minimum.

Example 12 may include the device of example 11 and/or any other example herein, wherein the at least one processor is further configured to: determine, based on the second position, a third distance between the second metal line at the second position and a fifth metal line of the electronic circuit; and determine, based on the second position, a fourth distance between the second metal line at the second position and a sixth metal line of the electronic circuit, wherein to determine the sixth position is further based on the third distance and the fourth distance.

Example 13 may include the device of example 12 and/or any other example herein, wherein the at least one processor is further configured to: determine a second difference between the third distance and the fourth distance; and determine a second minimum of the second distance and the variable, wherein to determine the sixth position is further based on the second minimum.

Example 14 may include the device of example 13 and/or any other example herein, wherein movement of the via from the third position to the sixth position comprises a first direction movement and a second direction movement.

Example 15 may include the device of example 9 and/or any other example herein, wherein to determine the fourth position and to determine the fifth position are based on a pitch awareness correction identification layer.

Example 16 may include an apparatus of a device for shifting layouts of electronic circuit vias during optical proximity corrections (OPC), the apparatus comprising at least one processor coupled to memory storing instructions that, when executed by the at least one processor, causes the device to: identify a first metal line, of an electronic circuit, drawn at a first position; identify a second metal line, of the electronic circuit, drawn at a second position; identify a via, of the electronic circuit, drawn at a third position extending between the first metal line and the second metal line; determine a fourth position to which the first metal line is to move from the first position; determine a fifth position to which the second metal line is to move from the second position; determine, based on the fourth position and the fifth position, a sixth position to which the via is to move from third position; and generate a photomask for the via at the sixth position.

Example 17 may include the apparatus of example 16 and/or any other example herein, wherein the at least one processor is further configured to: determine, based on the first position, a first distance between the first metal line at the fourth position and a third metal line of the electronic circuit; and determine, based on the first position, a second distance between the first metal line at the fourth position and a fourth metal line of the electronic circuit, wherein to determine the sixth position is further based on the first distance and the second distance.

Example 18 may include the apparatus of example 17 and/or any other example herein, wherein the at least one processor is further configured to: determine a difference between the first distance and the second distance; and determine a minimum of the difference and a variable indicative of an amount of allowed movement of the via from the third position, wherein to determine the sixth position is further based on the minimum.

Example 19 may include the apparatus of example 18 and/or any other example herein, wherein the at least one processor is further configured to: determine, based on the second position, a third distance between the second metal line at the second position and a fifth metal line of the electronic circuit; and determine, based on the second position, a fourth distance between the second metal line at the second position and a sixth metal line of the electronic circuit, wherein to determine the sixth position is further based on the third distance and the fourth distance.

Example 20 may include the apparatus of example 19 and/or any other example herein, wherein the at least one processor is further configured to: determine a second difference between the third distance and the fourth distance; and determine a second minimum of the second distance and the variable, wherein to determine the sixth position is further based on the second minimum.

Embodiments according to the disclosure are in particular disclosed in the attached claims directed to a method, a storage medium, a device and a computer program product, wherein any feature mentioned in one claim category, e.g., method, can be claimed in another claim category, e.g., system, as well. The dependencies or references back in the attached claims are chosen for formal reasons only. However, any subject matter resulting from a deliberate reference back to any previous claims (in particular multiple dependencies) can be claimed as well, so that any combination of claims and the features thereof are disclosed and can be claimed regardless of the dependencies chosen in the attached claims. The subject-matter which can be claimed comprises not only the combinations of features as set out in the attached claims but also any other combination of features in the claims, wherein each feature mentioned in the claims can be combined with any other feature or combination of other features in the claims. Furthermore, any of the embodiments and features described or depicted herein can be claimed in a separate claim and/or in any combination with any embodiment or feature described or depicted herein or with any of the features of the attached claims.

The foregoing description of one or more implementations provides illustration and description, but is not intended to be exhaustive or to limit the scope of embodiments to the precise form disclosed. Modifications and variations are possible in light of the above teachings or may be acquired from practice of various embodiments.

Certain aspects of the disclosure are described above with reference to block and flow diagrams of systems, methods, apparatuses, and/or computer program products according to various implementations. It will be understood that one or more blocks of the block diagrams and flow diagrams, and combinations of blocks in the block diagrams and the flow diagrams, respectively, may be implemented by computer-executable program instructions. Likewise, some blocks of the block diagrams and flow diagrams may not necessarily need to be performed in the order presented, or may not necessarily need to be performed at all, according to some implementations.

These computer-executable program instructions may be loaded onto a special-purpose computer or other particular machine, a processor, or other programmable data processing apparatus to produce a particular machine, such that the instructions that execute on the computer, processor, or other programmable data processing apparatus create means for implementing one or more functions specified in the flow diagram block or blocks. These computer program instructions may also be stored in a computer-readable storage media or memory that may direct a computer or other programmable data processing apparatus to function in a particular manner, such that the instructions stored in the computer-readable storage media produce an article of manufacture including instruction means that implement one or more functions specified in the flow diagram block or blocks. As an example, certain implementations may provide for a computer program product, comprising a computer-readable storage medium having a computer-readable program code or program instructions implemented therein, said computer-readable program code adapted to be executed to implement one or more functions specified in the flow diagram block or blocks. The computer program instructions may also be loaded onto a computer or other programmable data processing apparatus to cause a series of operational elements or steps to be performed on the computer or other programmable apparatus to produce a computer-implemented process such that the instructions that execute on the computer or other programmable apparatus provide elements or steps for implementing the functions specified in the flow diagram block or blocks.

Accordingly, blocks of the block diagrams and flow diagrams support combinations of means for performing the specified functions, combinations of elements or steps for performing the specified functions and program instruction means for performing the specified functions. It will also be understood that each block of the block diagrams and flow diagrams, and combinations of blocks in the block diagrams and flow diagrams, may be implemented by special-purpose, hardware-based computer systems that perform the specified functions, elements or steps, or combinations of special-purpose hardware and computer instructions.

Conditional language, such as, among others, "can," "could," "might," or "may," unless specifically stated otherwise, or otherwise understood within the context as used, is generally intended to convey that certain implementations could include, while other implementations do not include, certain features, elements, and/or operations. Thus, such conditional language is not generally intended to imply that features, elements, and/or operations are in any way required for one or more implementations or that one or more implementations necessarily include logic for deciding, with or without user input or prompting, whether these features, elements, and/or operations are included or are to be performed in any particular implementation.

Many modifications and other implementations of the disclosure set forth herein will be apparent having the benefit of the teachings presented in the foregoing descriptions and the associated drawings. Therefore, it is to be understood that the disclosure is not to be limited to the specific implementations disclosed and that modifications and other implementations are intended to be included within the scope of the appended claims. Although specific terms are employed herein, they are used in a generic and descriptive sense only and not for purposes of limitation.

**Claims**

1. A method for shifting layouts of electronic circuit vias during optical proximity corrections (OPC), the method comprising:

   identifying a first metal line, of an electronic circuit, drawn at a first position;
   identifying a second metal line, of the electronic circuit, drawn at a second position;
   identifying a via, of the electronic circuit, drawn at a third position extending between the first metal line and the second metal line;
   determining a fourth position to which the first metal line is to move from the first position;
   determining a fifth position to which the second metal line is to move from the second position;
   determining, based on the fourth position and the fifth position, a sixth position to which the via is to move from third position; and
   generating a layout associated with generating a photomask for the via at the sixth position.

2. The method of claim 1, further comprising:

   determining, based on the first position, a first distance between the first metal line at the fourth position and a third metal line of the electronic circuit; and
   determining, based on the first position, a second distance between the first metal line at the fourth position and a fourth metal line of the electronic circuit,
   wherein determining the sixth position is further based on the first distance and the second distance.

3. The method of claim 2, further comprising:

   determining a difference between the first distance and the second distance; and
   determining a minimum of the difference and a variable indicative of an amount of allowed movement of the via from the third position,
   wherein determining the sixth position is further based on the minimum.

4. The method of claim 3, further comprising:

   determining, based on the second position, a third distance between the second metal line at the second position and a fifth metal line of the electronic circuit; and
   determining, based on the second position, a fourth distance between the second metal line at the second position and a sixth metal line of the electronic circuit,
   wherein determining the sixth position is further based on the third distance and the fourth distance.

5. The method of claim 4, further comprising:

   determining a second difference between the third distance and the fourth distance; and
   determining a second minimum of the second distance and the variable,
   wherein determining the sixth position is further based on the second minimum.

6. The method of claim 5, wherein movement of the via from the third position to the sixth position comprises a first direction movement and a second direction movement.

7. The method of any one of claims 1-6, wherein determining the fourth position and determining the fifth position are based on a pitch awareness correction identification layer.

8. The method of any one of claims 1-7, further comprising:

   determining that the sixth position is within a distance from an edge of the first metal line at the fourth position; and
   extending the edge of the first metal line at the fourth position based on the determination that the sixth position is within the distance from the edge of the first metal line at the fourth position.

9. A device for shifting layouts of electronic circuit vias during optical proximity corrections (OPC), the device comprising at least one processor coupled to memory storing instructions that, when executed by the at least one processor, causes the device to:

identify a first metal line, of an electronic circuit, drawn at a first position;
identify a second metal line, of the electronic circuit, drawn at a second position;
identify a via, of the electronic circuit, drawn at a third position extending between the first metal line and the second metal line;
determine a fourth position to which the first metal line is to move from the first position;
determine a fifth position to which the second metal line is to move from the second position;
determine, based on the fourth position and the fifth position, a sixth position to which the via is to move from third position; and
generate a layout associated with generating a photomask for the via at the sixth position.

10. The device of claim 9, wherein the at least one processor is further configured to:

determine, based on the first position, a first distance between the first metal line at the fourth position and a third metal line of the electronic circuit; and
determine, based on the first position, a second distance between the first metal line at the fourth position and a fourth metal line of the electronic circuit,
wherein to determine the sixth position is further based on the first distance and the second distance.

11. The device of claim 10, wherein the at least one processor is further configured to:

determine a difference between the first distance and the second distance; and
determine a minimum of the difference and a variable indicative of an amount of allowed movement of the via from the third position,
wherein to determine the sixth position is further based on the minimum.

12. The device of claim 11, wherein the at least one processor is further configured to:

determine, based on the second position, a third distance between the second metal line at the second position and a fifth metal line of the electronic circuit; and
determine, based on the second position, a fourth distance between the second metal line at the second position and a sixth metal line of the electronic circuit,
wherein to determine the sixth position is further based on the third distance and the fourth distance.

13. The device of any one of claims 9-12, wherein the at least one processor is further configured to:

determine a second difference between the third distance and the fourth distance; and
determine a second minimum of the second distance and the variable,
wherein to determine the sixth position is further based on the second minimum.

14. An apparatus of a device for shifting layouts of electronic circuit vias during optical proximity corrections (OPC), the apparatus comprising at least one processor coupled to memory storing instructions that, when executed by the at least one processor, causes the device to:

identify a first metal line, of an electronic circuit, drawn at a first position;
identify a second metal line, of the electronic circuit, drawn at a second position;
identify a via, of the electronic circuit, drawn at a third position extending between the first metal line and the second metal line;
determine a fourth position to which the first metal line is to move from the first position;
determine a fifth position to which the second metal line is to move from the second position;
determine, based on the fourth position and the fifth position, a sixth position to which the via is to move from third position; and
generate a layout associated with generating a photomask for the via at the sixth position.

15. The apparatus of claim 14, wherein the at least one processor is further configured to:

determine, based on the first position, a first distance between the first metal line at the fourth position and a third metal line of the electronic circuit; and

determine, based on the first position, a second distance between the first metal line at the fourth position and a fourth metal line of the electronic circuit,

wherein to determine the sixth position is further based on the first distance and the second distance.

FIG. 1

FIG. 2

FIG. 3A

FIG. 3B

# FIG. 3A and FIG. 3B

EP 4 439 373 A1

FIG. 4

FIG. 5

FIG. 6

EP 4 439 373 A1

EP 4 439 373 A1

700

| 702 |
| --- |
| Generate Metal PAC ID Layer and Determine Metal Line Shifts |

| 704 |
| --- |
| Determine Via Positions Based on Metal Line Shifts (Via Pre-OPC Module) |

| 708 |
| --- |
| Generate Via Mask (Via OPC) |

| 706 |
| --- |
| Shifted Via Positions for Metal OPC and Post-OPC Metrology (Metal OPC) |

FIG. 7

EP 4 439 373 A1

FIG. 8

900

┌─────────────────────────────────────────┐
│ IDENTIFY A FIRST METAL LINE OF AN ELECTRONIC │ 902
│ CIRCUIT, DRAWN AT A FIRST POSITION │
└─────────────────────────────────────────┘

┌─────────────────────────────────────────┐
│ IDENTIFY A SECOND METAL LINE OF THE ELECTRONIC │ 904
│ CIRCUIT, DRAWN AT A SECOND POSITION │
└─────────────────────────────────────────┘

┌─────────────────────────────────────────┐
│ IDENTIFY A VIA OF THE ELECTRONIC CIRCUIT, DRAWN AT │ 906
│ A THIRD POSITION EXTENDING BETWEEN THE FIRST │
│ METAL LINE AND THE SECOND METAL LINE │
└─────────────────────────────────────────┘

┌─────────────────────────────────────────┐
│ DETERMINE A FOURTH POSITION TO WHICH THE FIRST │ 908
│ METAL LINE IS TO MOVE FROM THE FIRST POSITION │
└─────────────────────────────────────────┘

┌─────────────────────────────────────────┐
│ DETERMINE A FIFTH POSITION TO WHICH THE SECOND │ 910
│ METAL LINE IS TO MOVE FROM THE SECOND POSITION │
└─────────────────────────────────────────┘

┌─────────────────────────────────────────┐
│ DETERMINE, BASED ON THE FOURTH POSITION AND THE │ 912
│ FIFTH POSITION, A SIXTH POSITION TO WHICH THE VIA IS │
│ TO MOVE FROM THE THIRD POSITION │
└─────────────────────────────────────────┘

┌─────────────────────────────────────────┐
│ GENERATE A LAYOUT FOR USE IN GENERATING A │ 914
│ PHOTOMASK FOR THE VIA AT THE SIXTH POSITION │
└─────────────────────────────────────────┘

# FIG. 9

FIG. 10

Europäisches
Patentamt

European
Patent Office

Office européen
des brevets

# EUROPEAN SEARCH REPORT

Application Number

EP 23 21 4878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/306912 A1 (CHEN YEN-HUNG [TW] ET AL) 20 October 2016 (2016-10-20) * abstract; figures 1-6,9,10 * * paragraphs [0015], [0016], [0022] - [0026] * * claims 1,8-11 * | 1-15 | INV. G06F30/337 G03F1/36 G03F7/00 |
| X | US 2006/136861 A1 (LUCAS KEVIN D [FR] ET AL) 22 June 2006 (2006-06-22) * abstract; figures 1,2,9,10 * * paragraphs [0015] - [0018] * * claims 1-4 * | 1-15 | |

**TECHNICAL FIELDS SEARCHED (IPC)**

G03F
G06F

The present search report has been drawn up for all claims

| Place of search | Date of completion of the search | Examiner |
|---|---|---|
| Munich | 22 May 2024 | Pfaffelhuber, Thomas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 21 4878

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2024

| Patent document cited in search report | | Publication date | Patent family member(s) | | Publication date |
|---|---|---|---|---|---|
| US 2016306912 | A1 | 20-10-2016 | NONE | | |
| US 2006136861 | A1 | 22-06-2006 | TW | I375158 B | 21-10-2012 |
| | | | US | 2006136861 A1 | 22-06-2006 |
| | | | WO | 2006068788 A2 | 29-06-2006 |

EPO FORM P0459

For more details about this annex : see Official Journal of the European Patent Office, No. 12/82